# EUROPEAN PATENT APPLICATION

(11) **EP 4 243 072 A1**
(43) Date of publication of application: **13.09.2023**
(21) Application number: 21896653.9
(22) Date of filing: 21.10.2021
(51) Int. Cl.: H01L 25/16, H01L 23/367, H01L 23/04, H01L 23/10

(54) **ELECTRONIC COMPONENT AND ELECTRONIC DEVICE**

(30) Priority: 30.11.2020 CN 202011374920
(71) Applicant: Huawei Technologies Co., Ltd., Shenzhen, Guangdong 518129 (CN)
(72) Inventor: SUN, Jie, Shenzhen, Guangdong 518129 (CN); MO, Ruiming, Shenzhen, Guangdong 518129 (CN); YANG, Xichen, Shenzhen, Guangdong 518129 (CN); XU, Yi, Shenzhen, Guangdong 518129 (CN)
(74) Representative: Gill Jennings & Every LLP
(86) International application number: PCT/CN2021/125241
(87) International publication number: WO 2022/111151

(57) **Abstract**

Embodiments of this application disclose an electronic component and an electronic device, to achieve a three-dimensional stacked structure, reduce an area, and improve heat dissipation. In embodiments of this application, the electronic component includes an upper cover plate, a lower cover plate, and an enclosure frame. The upper cover plate carries a first circuit. The lower cover plate carries a second circuit. The enclosure frame is separately connected to the upper cover plate and the lower cover plate. An interconnection circuit is disposed in the enclosure frame, and the interconnection circuit is configured to implement interconnection between the first circuit and the second circuit. The first circuit and the second circuit overlap in a vertical direction without interfering with each other. Because a height of the enclosure frame is not lower than a preset height, and the preset height is higher than a sum of a height of the first circuit and a height of the second circuit, a three-dimensional stacked structure is achieved between the upper cover plate and the lower cover plate, thereby reducing an area of the electronic device.

## Description

This application claims priority to Chinese Patent Application No. 202011374920.1, filed with the Chinese National Intellectual Property Administration on November 30, 2020 and entitled ELECTRONIC COMPONENT AND ELECTRONIC DEVICE, which is incorporated herein by reference in its entirety.

### TECHNICAL FIELD

This application relates to the field of electronic device technologies, and in particular, to an electronic component and an electronic device.

### BACKGROUND

A power amplifier (PA for short) is a key component for power amplification in a radio base station. Performance indicators of the PA include saturation power and efficiency, which determine power consumption, size, and heat dissipation form requirements of the base station. Compared with a conventional power amplifier in a remote radio unit (remote radio unit, RRU), a PA in a massive multiple-input multiple-output (massive MIMO, MM) technology is characterized by low power, high integrity, and the like.

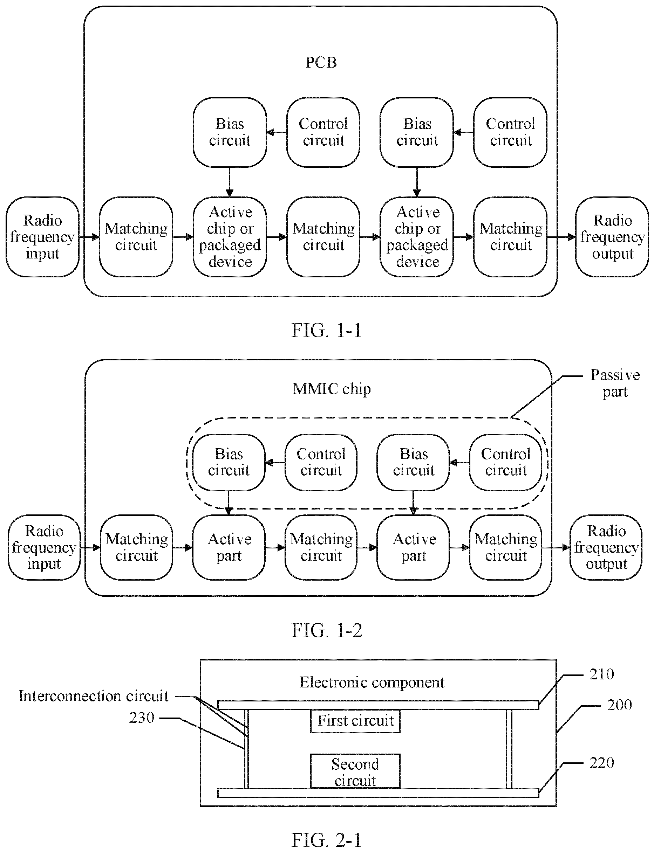

FIG. 1-1 is a schematic diagram of a packaged chip-based planar layout solution for a PA, and shows a typical two-stage amplification circuit, which includes components such as a bias circuit, a control circuit, a matching circuit, and an active chip. However, the four components are arranged in a same plane, leading to an excessively large size. Therefore, a miniaturization measure needs to be taken to meet a requirement of an MM product.

Currently, as shown in FIG. 1-2, in a monolithic microwave integrated circuit (monolithic microwave integrated circuit, MMIC) solution, a part of the matching circuit, a part of the bias circuit, and even a part of the control circuit are integrated onto the active chip. This can greatly reduce an area of an entire link, to meet a miniaturization requirement of the MM product.

However, to integrate a passive circuit and an active circuit onto an active chip, the passive circuit needs to be fabricated by using a same technique as the active circuit, resulting in high costs. Compared with a conventional surface-mounted device (surface-mounted device, SMD), the passive circuit integrated on the chip has a less satisfactory voltage resistance and Q value, affecting link performance (such as gain, efficiency, and saturation power). In addition, the chip requires a very long tape-out time (generally several months), has a very long performance iteration cycle, and requires very high tape-out costs.

### SUMMARY

This application provides an electronic component and an electronic device, to achieve a three-dimensional stacked structure, reduce an area, and improve heat dissipation.

A first aspect of this application provides an electronic component, including an upper cover plate, a lower cover plate, and an enclosure frame. The upper cover plate carries a first circuit. The lower cover plate carries a second circuit. The enclosure frame is separately connected to the upper cover plate and the lower cover plate. An interconnection circuit is disposed in the enclosure frame. The interconnection circuit is configured to implement interconnection between the first circuit and the second circuit. The first circuit and the second circuit overlap in a vertical direction without interfering with each other. Because a height of the enclosure frame is not lower than a preset height, and the preset height is higher than a sum of a height of the first circuit and a height of the second circuit, a three-dimensional stacked structure is achieved between the upper cover plate and the lower cover plate, thereby reducing an area of the electronic device.

In some possible implementations, a material of the enclosure frame is a PCB or a plastic article, and the enclosure frame is configured to be fixedly connected to the upper cover plate and the lower cover plate.

In some possible implementations, when the material of the enclosure frame is the PCB, an integrated passive circuit may be disposed in the enclosure frame, and is configured to transmit a direct current bias signal, a switch control signal, and/or a radio frequency signal between the first circuit and the second circuit. A commonly used integrated passive circuit includes a power splitter and/or a coupling circuit.

In some possible implementations, when the material of the enclosure frame is the plastic article, the integrated passive circuit may be disposed on the upper cover plate, not in the enclosure frame.

In some possible implementations, metalization treatment may be performed on the enclosure frame, so that the enclosure frame has a signal shielding capability, to shield a signal. Specifically, the metalization treatment may be electroplating, and a metal used may be copper, gold, nickel, palladium, or the like.

In some possible implementations, the first circuit includes an auxiliary circuit device, and the auxiliary circuit device includes a control circuit and/or a bias circuit. It should be noted that auxiliary circuit devices are all electrically conductive parts on circuits, such as those for control, measurement, signal and adjustment, and data processing in a complete set of equipment (other than a primary circuit).

In some possible implementations, a surface-mounted device (surface-mounted device, SMD) may also be used for matching in the first circuit. Compared with a high-integrity MMIC solution, the SMD has a smaller Q value and loss and better link performance (such as gain, efficiency, and saturation power), and requires lower costs.

In some possible implementations, the upper cover plate is disposed on a TRX board. In some possible implementations, the upper cover plate is a TRX board. This saves materials and reduces a weight. In some possible implementations, a material of the upper cover plate is a radio frequency board and the upper cover plate is connected to the TRX board through an LGA.

In some possible implementations, the second circuit includes an electronic component matching circuit, a core radio frequency matching circuit, and an active chip. Therefore, during development of the electronic component on a platform, different structures may be used to match different communication bands. Because the first circuit disposed on the lower cover plate 220 is an active circuit, a design may be made only on the lower cover plate 220. To be specific, the enclosure frame 230 and the upper cover plate 210 are reused, and only passive current matching needs to be designed, thereby enhancing supply continuity and development flexibility.

In some possible implementations, a surface-mounted device (surface-mounted device, SMD) may also be used for matching in the second circuit. Compared with a high-integrity MMIC solution, the SMD has a smaller Q value and loss and better link performance (such as gain, efficiency, and saturation power), and requires lower costs.

In some possible implementations, the second circuit is a discrete device or an unpackaged active chip. Because it is unnecessary to dispose a passive circuit on the lower cover plate, a defect of high costs due to that a same technique needs to be used for a passive circuit and an active part to integrate the passive circuit and the active part onto one single chip in conventional technologies is overcome. In addition, compared with the MMIC solution, because the second circuit is a discrete device or an unpackaged active chip, the chip requires a very short tape-out time and has a short performance iteration cycle. Considering that tape-out is very costly, this reduces costs and achieves high supply continuity.

In some possible implementations, the lower cover plate is disposed on a radiator.

In some possible implementations, a sintered block is disposed between the lower cover plate and the radiator.

A second aspect of this application provides an electronic device, including the electronic component in the implementations according to the first aspect.

It can be learned from the foregoing technical solutions that embodiments of this application have the following advantages:
The upper cover plate carries the first circuit. The lower cover plate carries the second circuit. The enclosure frame is separately connected to the upper cover plate and the lower cover plate. The interconnection circuit is disposed in the enclosure frame. The interconnection circuit is configured to implement interconnection between the first circuit and the second circuit. The first circuit and the second circuit overlap in the vertical direction without interfering with each other. Because the height of the enclosure frame is not lower than the preset height, and the preset height is higher than the sum of the height of the first circuit and the height of the second circuit, the three-dimensional stacked structure is achieved between the upper cover plate and the lower cover plate, thereby reducing the area of the electronic device.

### BRIEF DESCRIPTION OF DRAWINGS

FIG. 1-1 is a schematic diagram of a two-stage amplification circuit;
FIG. 1-2 is a schematic diagram of an integrated chip of an MMIC solution;
FIG. 2-1 is a schematic diagram of an electronic component according to an embodiment of this application;
FIG. 2-2 is a schematic diagram of a physical electronic component according to an embodiment of this application;

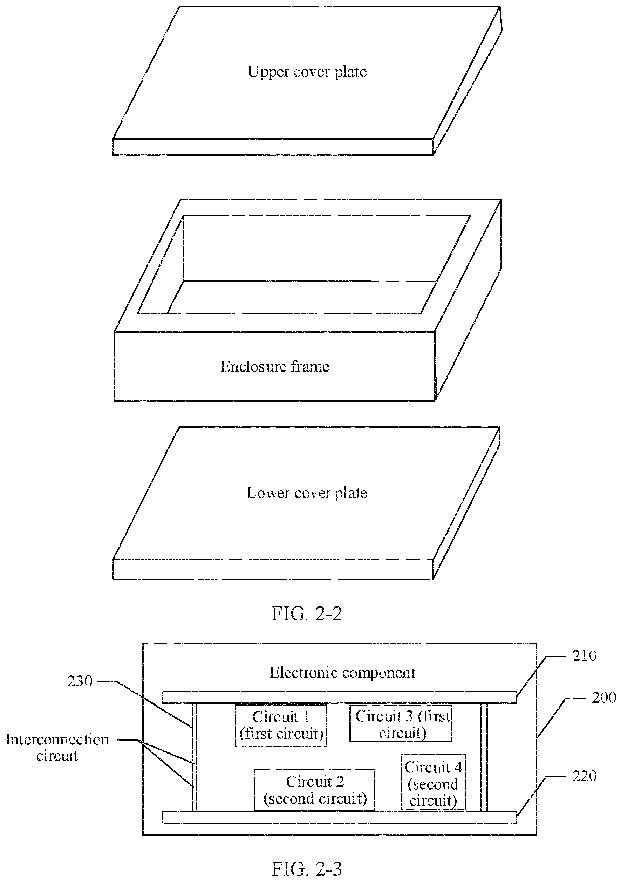

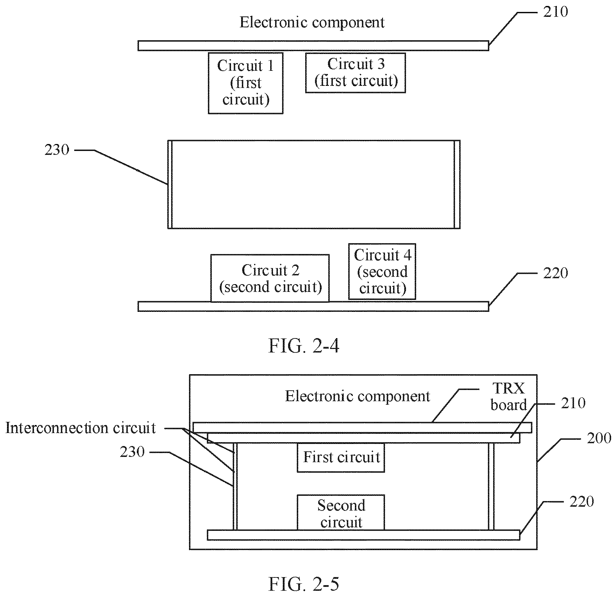

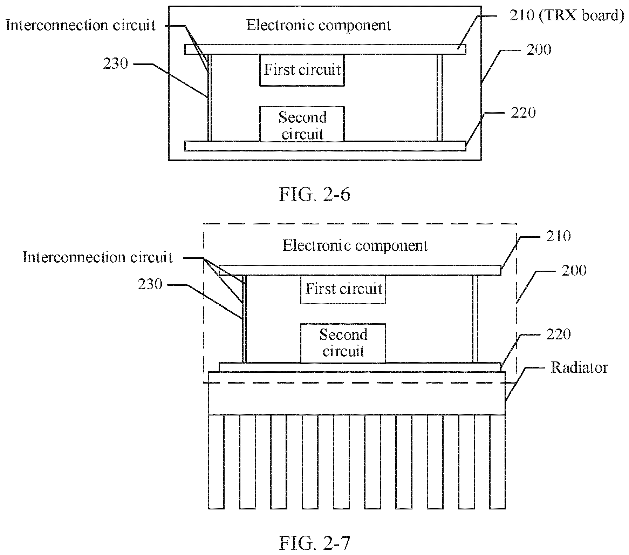

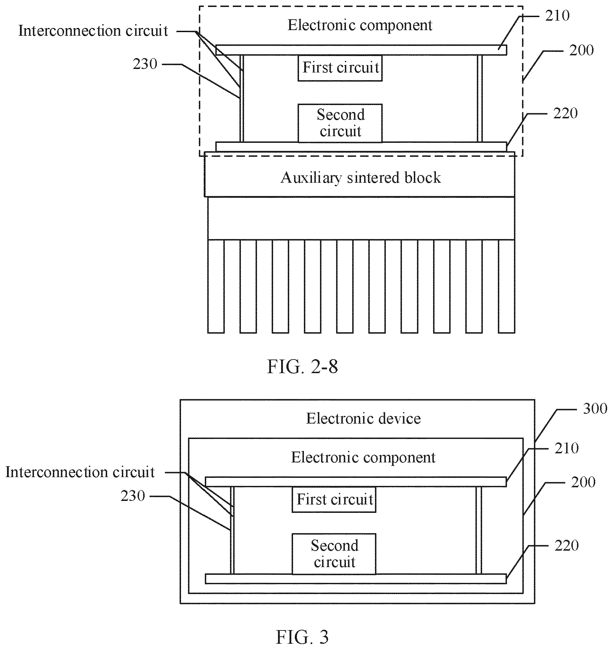

FIG. 2-3 is another schematic diagram of an electronic component according to an embodiment of this application;
FIG. 2-4 is an exploded view of an electronic component observed in a horizontal direction according to an embodiment of this application;
FIG. 2-5 is a schematic diagram of an electronic component in which an upper cover plate may be arranged on a TRX board according to an embodiment of this application;
FIG. 2-6 is a schematic diagram of an electronic component in which a TRX board is used as an upper cover plate according to an embodiment of this application;
FIG. 2-7 is a schematic diagram in which a lower cover plate is disposed on a radiator according to an embodiment of this application;
FIG. 2-8 is a schematic diagram in which a lower cover plate is welded to an auxiliary sintered block according to an embodiment of this application; and
FIG. 3 is a schematic diagram of an embodiment of an electronic device according to an embodiment of this application.

### DESCRIPTION OF EMBODIMENTS

Embodiments of this application provide an electronic component and an electronic device, to achieve a three-dimensional stacked structure, reduce an area, and improve heat dissipation.

In embodiments of this application, an electronic component is a basic element in an electronic circuit, is usually packaged individually, and has two or more pins. For example, the electronic component is a power amplifier module (power amplifier module, PAM). An electronic device is a device that has an internal electronic circuit and achieves a function through electronic technologies and software. A circuit is a structure including a dielectric layer, and lines, pads, and vias disposed on the dielectric layer, and is configured to implement interconnection between electronic components to form an electronic circuit having a specific function, for example, a massive multiple-input multiple-output (massive multiple-input multiple-output, Massive MIMO) antenna transceiver circuit in a radio base station.

A power amplifier (PA for short) is a key component for power amplification in a radio base station. Performance indicators of the PA include saturation power and efficiency, which determine power consumption, size, and heat dissipation form requirements of the base station. Compared with a conventional power amplifier in an RRU, a PA in an MM technology is characterized by low power, high integrity, and the like. A typical two-stage amplification circuit includes components such as a bias feed circuit, a control circuit, a radio frequency matching circuit, and an active chip. However, these components are arranged in a same plane, leading to an excessively large size. Therefore, a miniaturization measure needs to be taken to meet a requirement of an MM product.

In a monolithic microwave integrated circuit (monolithic microwave integrated circuit, MMIC) solution, a part of the matching circuit, a part of the bias circuit, and even a part of the control circuit are integrated onto a chip. This can greatly reduce an area of an entire link, to meet a miniaturization requirement of the MM product. However, to integrate a passive circuit and an active circuit onto a chip, the passive circuit needs to be fabricated by using a same technique as the active circuit, resulting in high costs. Compared with a conventional SMD, the passive circuit integrated on the chip has a less satisfactory voltage resistance and Q value, affecting link performance (such as gain, efficiency, and saturation power). In addition, the chip requires a very long tape-out time (generally several months), has a very long performance iteration cycle, and requires very high tape-out costs.

Refer to FIG. 2-1. In view of this, this application provides an electronic component 200, including: an upper cover plate 210, a lower cover plate 220, and an enclosure frame 230. The upper cover plate 210 carries a first circuit. The lower cover plate 220 carries a second circuit. The enclosure frame 230 is separately connected to the upper cover plate 210 and the lower cover plate 220. An interconnection circuit is disposed in the enclosure frame 230. The interconnection circuit is configured to implement interconnection between the first circuit and the second circuit.

In embodiments of this application, the electronic component 200 may be a power amplifier or other electronic components in a base station. This is not limited herein.

Specifically, FIG. 2-2 is an exploded view of the electronic component 200. FIG. 2-3 is an assembled view of the electronic component 200 observed in a horizontal direction. FIG. 2-4 is an exploded view of the electronic component 200 observed in the horizontal direction.

The following separately describes in detail the enclosure frame 230, the upper cover plate 210, and the lower cover plate 220 in embodiments of this application.

### 1. Enclosure frame 230.

### 1. Height of the enclosure frame 230.

n embodiments of this application, because the height of the enclosure frame 230 is not lower than a preset height, and the preset height is higher than a sum of a height of the first circuit and a height of the second circuit, a three-dimensional stacked structure is achieved between the upper cover plate 210 and the lower cover plate 220, thereby reducing an area of the electronic device 200.

For example, as shown in FIG. 2-3, the height of the first circuit is 1 millimeter (mm), the height of the second circuit is 1.5 mm, and the height of the enclosure frame 230 is 3 mm. Because 3 mm > 1 mm + 1.5 mm, a three-dimensional stacked structure is achieved when the upper cover plate 210 carries the first circuit and the lower cover plate 220 carries the second circuit, thereby reducing the area of the electronic component 200. In other words, given a same area, more circuits may be disposed in the electronic component 200.

On the contrary, if the height of the first circuit is 2 millimeter (mm), the height of the second circuit is 2 mm, and the height of the enclosure frame 230 is 3.5 mm, a three-dimensional stacked structure cannot be implemented when the upper cover plate 210 carries the first circuit and the lower cover plate 220 carries the second circuit because 3.5 mm < 2 mm + 2 mm, and consequently the area of the entire electronic component cannot be reduced.

Preferably, the height of the enclosure frame 230 does not exceed another preset value, so as not to waste space, not to increase a difficulty in communication between the first circuit and the second circuit, not to increase a difficulty in matching and not to affect structural strength. For example, the height of the first circuit is 1 mm, the height of the second circuit is 1 mm, and the sum of the height of the first circuit and the height of the second circuit is 2 mm. If the height of the enclosure frame 230 is set to 10 mm, an unnecessary waste of space is caused.

It should be noted that, the first circuit and the second circuit are circuits that overlap in a vertical direction without interfering with each other, for example, circuit 1 and circuit 2, or circuit 3 and circuit 4, or circuit 2 and circuit 3 shown in FIG. 2-3. It is not the case with circuit 1 and circuit 4. In embodiments of this application, "without interfering with each other" means that two circuits are not in contact with each other.

In embodiments of this application, as shown in FIG. 2-3, the interconnection circuit is disposed in the enclosure frame 230. The interconnection circuit may be disposed on a side wall of the enclosure frame 230. The interconnection circuit is configured to be separately connected to the first circuit and the second circuit, to implement interconnection between the first circuit and the second circuit.

### 2. Material of the enclosure frame 230.

In some possible implementations, the material of the enclosure frame 230 may be a printed circuit board (printed circuit board, PCB) or a plastic article, and the enclosure frame 230 is configured to fix the upper cover plate 210 and the lower cover plate 220.

The PCB is an important electronic part and is widely used in manufacturing of electronic products. The PCB may replace complex wiring, to implement electrical connection between components in a circuit. This simplifies assembly and welding work of an electronic product, reduces wiring workload required in a conventional process, and greatly reduces labor intensity of workers.

In some possible implementations, the enclosure frame 230 may also be made of other materials. This is not limited herein.

### 3. An integrated passive circuit is disposed in the enclosure frame 230.

In some possible implementations, when the material of the enclosure frame 230 is the PCB, the integrated passive circuit configured to communicate between the first circuit and the second circuit may be disposed in the enclosure frame 230.

It should be noted that a commonly used integrated passive circuit includes a power splitter and/or a coupling circuit. The power splitter is a device that splits energy of one input signal into two or more outputs with equal or unequal energy, and may also combine energy of multiple signals into one output. In this case, the power splitter may also be referred to as a combiner. The coupling circuit is a circuit that connects functional circuits to implement transmission of energy and signals.

In embodiments of this application, after the integrated passive circuit is disposed in the enclosure frame 230, a direct current bias signal, a switch control signal, and/or a radio frequency signal may be transmitted between the first circuit and the second circuit.

In some possible implementations, when the material of the enclosure frame 230 is the plastic article, the integrated passive circuit may be disposed on the upper cover plate 210, not in the enclosure frame.

### 4. The enclosure frame 230 encounters metalization treatment.

To prevent signal leakage during communication between the first circuit and the second circuit, metalization treatment may be performed on the enclosure frame 230 to shield a signal. Specifically, the metalization treatment may be electroplating, and a metal used may be copper, gold, nickel, palladium, or the like. In embodiments of this application, metalization treatment is performed on the enclosure frame 230, so that the enclosure frame 230 has a signal shielding capability.

### 11. Upper cover plate 210.

### 1. Composition of the first circuit.

In some possible implementations, the first circuit may include an auxiliary circuit device, and the auxiliary circuit device includes a passive circuit such as a control circuit and/or a bias circuit.

It should be noted that auxiliary circuit devices are all electrically conductive parts on circuits, such as those for control, measurement, signal and adjustment, and data processing in a complete set of equipment (other than a primary circuit).

In embodiments of this application, the control circuit is a circuit used for mechanical and electrical device control (including inspection) according to Terms and Definitions in GB/T 5226.1-2019/IEC 60204-1:2016.

It should be noted that, to enable an amplifier formed by a transistor to amplify a signal voltage without distortion, it needs to be ensured that an emitter junction is positively biased and a collector junction is reversely biased in the transistor. In other words, operating points of the transistor should be set. The operating point is a point at which a base, an emitter, and a collector of the transistor are at required potentials (which may be obtained through calculation) through arrangement of external circuits. These external circuits are referred to as bias circuits.

In some possible implementations, a surface-mounted device (surface-mounted device, SMD) may also be used for matching in the first circuit. Compared with a high-integrity MMIC solution, the SMD has a smaller Q value and loss and better link performance (such as gain, efficiency, and saturation power), and requires lower costs.

### 2. The upper cover plate 210 is disposed on a transceiver unit (transceiver, TRX) board.

In some possible implementations, the electronic component 200 may be a power amplifier, and as shown in FIG. 2-5, may have a TRX board. The upper cover plate 210 may be disposed on the TRX board.

In some possible implementations, a material of the upper cover plate 210 is a radio frequency board, and the upper cover plate 210 may be interconnected with the TRX board through a land grid array (land grid array, LGA). It should be noted that the LGA corresponds to a previous packaging technology, Socket 478, of Intel processors, and is also referred to as Socket T. The LGA mainly uses metal contact packaging to replace conventional needle-like pins.

### 3. The upper cover plate 210 is a TRX board.

In some possible implementations, as shown in FIG. 2-6, the TRX board may be used as the upper cover plate 210, thereby saving materials and reducing a weight.

During development of the electronic component on a platform, different structures may be used to match different communication bands. Because the first circuit disposed on the lower cover plate 220 is an active circuit, a design may be made only on the lower cover plate 220. To be specific, the enclosure frame 230 and the upper cover plate 210 are reused, and therefore, only a passive circuit needs to be designed, thereby enhancing supply continuity and development flexibility.

### III. Lower cover plate 220.

In an embodiment of this application, a material of the lower cover plate 220 is a PCB, and the lower cover plate is configured to carry the second circuit.

### 1. Composition of the second circuit.

In some possible implementations, the second circuit includes active circuits such as a power amplifier matching circuit, a core radio frequency matching circuit, and an active chip. Because it is unnecessary to dispose a passive circuit on the lower cover plate 220, a defect of high costs due to that a same technique needs to be used for a passive circuit and an active part to integrate the passive circuit and the active part onto one single chip in conventional technologies is overcome.

In some possible implementations, a surface-mounted device (surface-mounted device, SMD) may also be used for matching in the second circuit. Compared with a high-integrity MMIC solution, the SMD has a smaller Q value and loss and better link performance (such as gain, efficiency, and saturation power), and requires lower costs.

### 2. Form of the second circuit.

In some possible implementations, the second circuit is a discrete device or an unpackaged active chip.

It should be noted that the discrete device is a miniature electronic component or part. Components such as a transistor, a diode, a resistor, a capacitor, and an inductor, and a wiring that are required in a circuit are interconnected together using a specific process, integrated on one or several small semiconductor wafers or dielectric substrates, and then packaged in a tubular casing, to form a miniature structure having a required circuit function.

The unpackaged active chip, or referred to as a die (die), is a chip produced in a foundry (foundry), has only bonding pads (pads) for packaging, and cannot be directly used in an actual circuit. A die is a chip produced by a foundry (manufacturing factory), to be specific, is a chip that is not packaged after wafer dicing and testing.

Compared with the MMIC solution, because the second circuit is a discrete device or an unpackaged active chip, the chip requires a very short tape-out time and has a short performance iteration cycle. Considering that tape-out is very costly, this reduces costs and achieves high supply continuity.

### 3. The lower cover plate 220 is disposed on a radiator.

Currently, in a mainstream MIMO solution in the industry , a TRX board exists between an active chip and a radiator. In embodiments of this application, because the upper cover plate 210 is connected to the TRX board, or the upper cover plate 210 is the TRX board, as shown in FIG. 2-7, the lower cover plate 220 may be disposed on the radiator. This is more conducive to heat dissipation of the active circuit (the second circuit) on the lower cover plate 220.

Optionally, as shown in FIG. 2-8, a sintered block may be disposed between the lower cover plate 220 and the radiator. The sintered block is configured to assist in heat dissipation, to reduce a temperature of the second circuit, and improve a heat dissipation capability and a power capacity of an entire module.

Refer to FIG. 3. This application further provides an electronic device 300, including the electronic component 200 described above. The electronic device 300 includes but is not limited to a power amplifier.

In the descriptions of this specification, the specific features, structures, materials, or characteristics may be combined in a proper manner in any one or more of embodiments or examples.

Finally, it should be noted that the foregoing embodiments are merely intended for describing technical solutions of this application, but not for limiting this application. Although this application is described in detail with reference to the foregoing embodiments, persons of ordinary skill in the art should understand that modifications may still be made to the technical solutions described in the foregoing embodiments or equivalent replacements may be made to some technical features, and such modifications and replacements do not cause the essence of the corresponding technical solutions to depart from the spirit and scope of technical solutions of embodiments of this application.

## Claims

1. An electronic component, comprising:
an upper cover plate, a lower cover plate, and an enclosure frame, wherein
the upper cover plate carries a first circuit, the lower cover plate carries a second circuit, and the enclosure frame is separately connected to the upper cover plate and the lower cover plate;
an interconnection circuit is disposed in the enclosure frame, the interconnection circuit is configured to implement interconnection between the first circuit and the second circuit, and the first circuit and the second circuit overlap in a vertical direction without interfering with each other; and
a height of the enclosure frame is not lower than a preset height, and the preset height is higher than a sum of a height of the first circuit and a height of the second circuit.

2. The electronic component according to claim 1, wherein an integrated passive circuit is disposed in the enclosure frame, and is configured to transmit a direct current bias signal, a switch control signal, and/or a radio frequency signal between the first circuit and the second circuit.

3. The electronic component according to claim 2, wherein the integrated passive circuit comprises a power splitter and/or a coupling circuit.

4. The electronic component according to any one of claims 1 to 3, wherein a material of the enclosure frame is a PCB or a plastic article.

5. The electronic component according to any one of claims 1 to 4, wherein the enclosure frame encounters metalization treatment to shield a signal.

6. The electronic component according to claim 5, wherein the metalization treatment is electroplating treatment.

7. The electronic component according to any one of claims 1 to 6, wherein the first circuit comprises an auxiliary circuit device, and the auxiliary circuit device comprises a control circuit and/or a bias circuit.

8. The electronic component according to any one of claims 1 to 7, wherein the upper cover plate is a TRX board.

9. The electronic component according to any one of claims 1 to 7, wherein the upper cover plate is disposed on a TRX board.

10. The electronic component according to claim 9, wherein a material of the upper cover plate is a radio frequency board and the upper cover plate is connected to the TRX board through an LGA.

11. The electronic component according to any one of claims 1 to 10, wherein the second circuit comprises an electronic component matching circuit, a core radio frequency matching circuit, and an active chip.

12. The electronic component according to any one of claims 1 to 11, wherein the second circuit is a discrete device or an unpackaged active chip.

13. The electronic component according to any one of claims 1 to 12, wherein the lower cover plate is disposed on a radiator.

14. The electronic component according to claim 13, wherein a sintered block is disposed between the lower cover plate and the radiator.

15. An electronic device, comprising the electronic component according to any one of claims 1 to 14.
